(19) **Europäisches Patentamt European Patent Office Office européen des brevets**

(11) **EP 3 173 800 B1**

(12) **FASCICULE DE BREVET EUROPEEN**

(45) Date de publication et mention de la délivrance du brevet:
**25.02.2026 Bulletin 2026/09**

(21) Numéro de dépôt: **16200788.4**

(22) Date de dépôt: **25.11.2016**

(51) Classification Internationale des Brevets (IPC):
**G01R 22/06** *(2006.01)*   **G01R 31/54** *(2020.01)*
**H02H 3/353** *(2006.01)*   **H02H 5/10** *(2006.01)*

(52) Classification Coopérative des Brevets (CPC):
**G01R 22/061;** G01R 22/066; G01R 31/54;
H02H 3/353; H02H 5/10

(54) **PROCEDE DE DETECTION D'UNE ABSENCE DE NEUTRE EN AMONT D'UN COMPTEUR ET COMPTEUR, PROGRAMME D'ORDINATEUR ET SUPPORT DE PROGRAMME POUR LA MISE EN OEUVRE DE CE PROCEDE**

VERFAHREN ZUR DETEKTION DES FEHLENS EINES VOR EINEN ZÄHLER VORGESCHALTETEN NULLLEITERS UND ZÄHLER, COMPUTERPROGRAMM UND PROGRAMMSUPPORT FÜR DIE UMSETZUNG DIESES VERFAHRENS

METHOD FOR DETECTING AN ABSENCE OF NEUTRAL UPSTREAM FROM A COUNTER AND METER, COMPUTER PROGRAM AND PROGRAM MEDIUM FOR CARRYING OUT SAID METHOD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **27.11.2015 FR 1561520**

(43) Date de publication de la demande:
**31.05.2017 Bulletin 2017/22**

(73) Titulaire: **SAGEMCOM ENERGY & TELECOM SAS**
**92270 Bois-Colombes (FR)**

(72) Inventeurs:
- **PALLAVISINI, Aurélien**
  **92270 BOIS-COLOMBES (FR)**
- **GEHENIAU, Frédéric**
  **92270 BOIS-COLOMBES (FR)**

(74) Mandataire: **Cabinet Boettcher et al**
**5, rue de Vienne**
**75008 Paris (FR)**

(56) Documents cités:
FR-A1- 3 020 468     JP-A- 2009 048 864
US-B1- 6 236 197

**Description**

La présente invention concerne la mesure de consommation d'énergie d'une installation électrique reliée à un réseau de distribution polyphasé.

ETAT DE LA TECHNIQUE

Il est connu de raccorder chaque installation électrique consommatrice à plusieurs phases d'un réseau de distribution polyphasé par l'intermédiaire d'un compteur agencé pour mesurer la quantité totale d'énergie consommée par l'installation électrique.

Dans un réseau polyphasé, l'un des problèmes les plus graves qui puisse survenir est une rupture de neutre en amont du compteur. En effet, dans un tel cas, les déséquilibres entre phases donnent naissance à des tensions importantes susceptibles de détériorer des équipements de l'installation électrique.

Il existe désormais en outre des compteurs pourvus de moyens de communication par courant porteur en ligne (ou CPL) permettant l'échange de données entre les compteurs et des unités de concentration de données pour faciliter la gestion du comptage. Les données sont transmises par le compteur en injectant des signaux de données sur une des phases du réseau de distribution. Les données transmises comprennent des données relatives à la consommation de l'installation. Il a été envisagé d'utiliser les signaux de données pour faire remonter des alertes relatives à des anomalies détectables par le compteur.

Il serait donc intéressant que les compteurs puissent détecter une rupture de neutre soit pour alerter l'utilisateur soit pour alerter l'exploitant du réseau de distribution.

OBJET DE L'INVENTION

Un but de l'invention est de fournir un moyen pour détecter une rupture de neutre dans un réseau de distribution électrique depuis un compteur relié au réseau de distribution et à une installation consommatrice.

BREF EXPOSE DE L'INVENTION

A cet effet, on prévoit, selon l'invention, un procédé de détection d'une absence de neutre selon la revendication 1.

Lorsque le réseau a son neutre correctement connecté, le rapport de tension est égal à 1. En revanche, ce rapport devient supérieur à 1 lorsque le neutre disparaît et que les 3 impédances en aval du compteur ne sont pas équilibrées. Il est donc aisé de détecter une absence de neutre avec le procédé de l'invention.

L'invention a également pour objet un compteur électrique pour la mise en œuvre de ce procédé.

L'invention concerne en outre un produit programme d'ordinateur et un support de programme d'ordinateur pour la mise en œuvre de ce procédé.

D'autres caractéristiques et avantages de l'invention ressortiront à la lecture de la description qui suit de modes de réalisation particuliers non limitatifs de l'invention.

BREVE DESCRIPTION DES FIGURES

Il sera fait référence aux dessins annexés, parmi lesquels :

- la figure 1 est une vue schématique d'un compteur selon l'invention,
- la figure 2 est un schéma illustrant le déroulement du procédé de l'invention.

DESCRIPTION DETAILLEE DE L'INVENTION

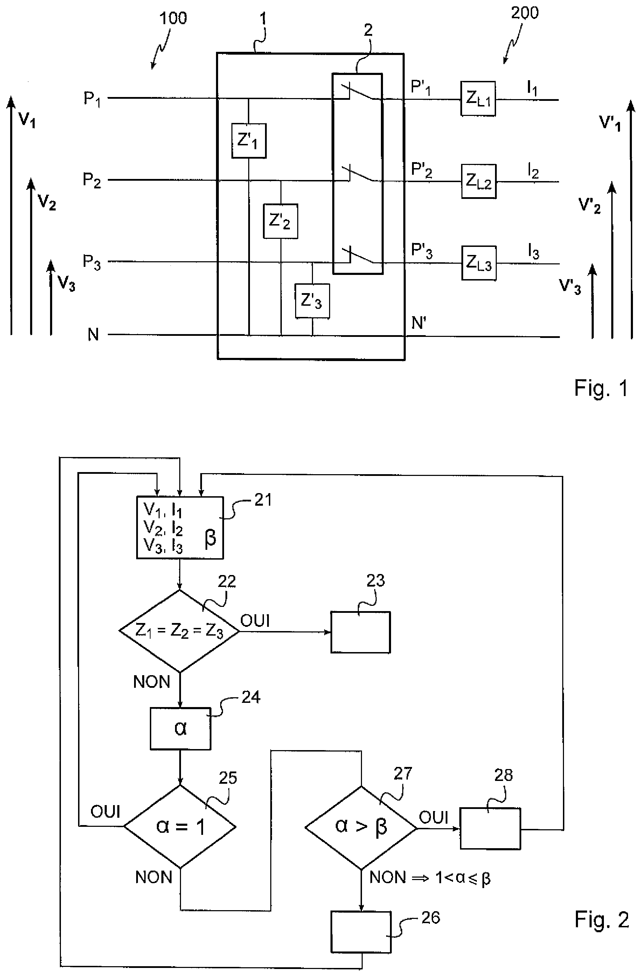

En référence à la figure 1, le compteur électrique selon l'invention, généralement désigné en 1, est agencé pour raccorder un réseau de distribution électrique 100 à une installation électrique 200 consommatrice d'électricité. Le réseau de distribution électrique 100 est un réseau triphasé comprenant trois phases $P_1$, $P_2$, $P_3$ et un neutre N : un tel réseau est connu en lui-même et ne sera pas plus détaillé ici. L'installation électrique 200 comprend trois phases $P'_1$, $P'_2$, $P'_3$ et un neutre N' : une telle installation est connue en elle-même et ne sera pas plus détaillée ici.

Le compteur 1 comprend :

- des moyens de mesure de tension entre les phases $P_1$, $P_2$, $P_3$, le neutre N et un potentiel de référence du compteur 1,
- des moyens de mesure d'intensité sur chaque phase $P'_1$, $P'_2$, $P'_3$,
- un dispositif de déconnexion 2 du compteur 1 vis-à-vis du réseau 100,
- une unité de commande qui est reliée aux différents moyens de mesure et au dispositif de déconnexion 2 et qui comporte un processeur relié à une mémoire contenant un programme exécutable par le processeur et agencé pour mettre en œuvre le procédé de l'invention permettant de détecter une absence de neutre dans le réseau de distribution 100 en amont du compteur 1. Les moyens de stockage informatique du programme peuvent être une mémoire montée à demeure dans l'unité de commande ou un support amovible de données (support mémoire de type USB par exemple). Le programme informatique peut être enregistré dans la mémoire en usine ou téléchargé depuis un support mémoire qui serait temporairement relié à l'unité de commande.

L'unité de commande du compteur 1 est en outre ici agencée pour transmettre des signaux de données sur l'une des phases du réseau 100 (injection de signaux CPL) pour transmettre des données de consom-

En fonctionnement, outre les tâches classiques de comptage d'énergie, le procédé selon l'invention prévoit de périodiquement mesurer les tensions $V_1$, $V_2$, $V_3$ entre les phases $P_1$, $P_2$, $P_3$ et le neutre N et calculer les impédances $Z_1$, $Z_2$, $Z_3$ des phases en aval du compteur (étape 21) .

Les impédances $Z_i$ sont égales à $(Z_i - Z_{Li})/(Z_i + Z_{Li})$ pour i variant de 1 à 3, où $Z'_i$ sont les impédances internes au compteur 1 et $Z_{Li}$ sont les impédances sur chaque phase $P'_i$.

Ceci permet de calculer la tension $V'_N$ qui résulte de l'égalité suivante :

$$\frac{\vec{V1}}{Z1} + \frac{\vec{V2}}{Z2} + \frac{\vec{V3}}{Z3} = \vec{V}'N(\frac{1}{Z1} + \frac{1}{Z2} + \frac{1}{Z3}) .$$

Ceci permet aussi, de manière connue en soi, de calculer les tensions efficaces $V'_1$, $V'_2$, $V'_3$ aux bornes de chacune des charges de l'installation consommatrice 200.

Enfin est périodiquement calculé un seuil $\beta$ égal au rapport entre la plus forte des impédances $Z_i$ et la plus faible des impédances $Z_i$. Ce seuil est mémorisé dans l'unité de commande du compteur 1 pour pouvoir être ultérieurement utilisé.

Le procédé se poursuit par l'étape 22 de comparer les impédances $Z_1$, $Z_2$, $Z_3$ en elles.

Lorsque les impédances $Z_1$, $Z_2$, $Z_3$ sont égales entre elles, l'unité de commande émet une alerte indiquant que la détection d'absence de neutre est impossible (étape 23).

Lorsque les impédances $Z_1$, $Z_2$, $Z_3$ sont inégales entre elles, la détection d'absence de neutre est poursuivie.

Il est alors procédé au calcul d'un rapport $\alpha$ entre la plus forte des tensions $V'_1$, $V'_2$, $V'_3$ et la plus faible des tensions $V'_1$, $V'_2$, $V'_3$ (étape 24)

Lorsque ce rapport $\alpha$ est supérieur à 1, l'unité de commande émet une alerte représentative d'une absence de neutre (étape 26).

De préférence ici, le procédé comprend également l'étape 28 d'actionner le dispositif de déconnexion 2 du compteur 1 en cas de détection d'une absence de neutre. Plus précisément, le dispositif de déconnexion 2 n'est actionné que si le rapport de tensions $\alpha$ est supérieur au seuil $\beta$. La valeur de seuil $\beta$ utilisée pour la comparaison avec le rapport de tensions $\alpha$ est la dernière valeur de seuil $\beta$ déterminée avant la détection d'absence de neutre.

En cas de rupture de neutre, la tension $V'_N$ devient nulle et engendre un déséquilibre entre les tensions $V'_1$, $V'_2$, $V'_3$ : le rapport de tensions $\alpha$ devient supérieur à 1. On considère que, lorsque le rapport $\alpha$ est inférieur au seuil $\beta$, le risque de dégradation de l'installation 200 est faible voire inexistant : il n'est donc pas nécessaire d'isoler l'installation 200 vis-à-vis du réseau 100.

Bien entendu, l'invention n'est pas limitée aux modes de réalisation décrits mais englobe toute variante entrant dans le champ de l'invention telle que définie par les revendications.

En particulier, l'invention s'applique à tout réseau de distribution électrique comprenant au moins deux phases et un neutre.

Le procédé pourrait ne pas comprendre de phase d'alerte tant que le rapport de tensions $\alpha$ reste inférieur au seuil $\beta$.

Il est possible d'avoir un seuil qui ne soit pas modifié dynamiquement mais fixé une fois pour toutes.

## Revendications

1. Procédé de détection d'une absence de neutre dans un réseau polyphasé depuis un compteur raccordant une installation consommatrice au réseau de distribution, le procédé comprenant les étapes de :

   - déterminer des impédances des phases en aval du compteur,
   - lorsque les impédances sont égales entre elles, émettre une alerte indiquant que la détection d'absence de neutre est impossible,
   - lorsque les impédances sont inégales entre elles, déterminer les tensions efficaces entre les phases en aval du compteur et un potentiel de référence du compteur,
   - calculer un rapport entre la plus forte de ces tensions et la plus faible de ces tensions,
   - lorsque ce rapport est supérieur à 1, émettre une alerte représentative d'une absence de neutre et actionner un dispositif de déconnexion du compteur en cas de détection d'une absence de neutre si le rapport de tension est supérieur à une valeur de seuil supérieure à 1 et égale à un rapport entre la plus forte des impédances des phases et la plus faible des impédances des phases.

2. Procédé selon la revendication 1, dans lequel la valeur de seuil est déterminée périodiquement et la valeur de seuil utilisée pour la comparaison avec le rapport de tensions est la dernière valeur de seuil déterminée avant la détection d'absence de neutre.

3. Compteur pour réseau polyphasé, comprenant :

   - des moyens de mesure de tension entre les phases et un potentiel de référence du compteur,
   - une unité de commande reliée aux moyens de mesure de tension et programmée pour mettre en œuvre le procédé selon l'une quelconque des revendications précédentes.

**4.** Produit programme d'ordinateur pour la mise en œuvre du procédé selon l'une quelconque des revendications 1 et 2.

**5.** Moyens de stockage informatique contenant un programme d'ordinateur agencé pour la mise en œuvre du procédé selon l'une quelconque des revendications 1 et 2.

**Patentansprüche**

**1.** Detektionsverfahren zur Detektion eines fehlenden Neutralleiters in einem Mehrphasennetz ausgehend von einem Zähler, der eine Verbraucheranlage mit dem Verteilungsnetz verbindet, wobei das Verfahren die Schritte umfasst, dass:

- Impedanzen der Phasen stromabwärts von dem Zähler bestimmt werden,
- wenn die Impedanzen untereinander gleich sind, eine Warnmeldung ausgegeben wird, wonach die Detektion eines fehlenden Neutralleiters nicht möglich ist,
- wenn die Impedanzen untereinander ungleich sind, die Effektivspannungen zwischen den Phasen stromabwärts von dem Zähler und einem Bezugspotenzial des Zählers bestimmt werden,
- ein Verhältnis zwischen der höchsten dieser Spannungen und der niedrigsten dieser Spannungen berechnet wird,
- wenn dieses Verhältnis größer als 1 ist, eine Warnmeldung, die ein Fehlen des Neutralleiters darstellt, ausgegeben wird, und im Falle der Detektion eines fehlenden Neutralleiters eine Abtrennvorrichtung zum Abtrennen des Zählers betätigt wird, wenn das Spannungsverhältnis über einem Schwellenwert liegt, welcher größer als 1 ist und einem Verhältnis zwischen der höchsten der Phasenimpedanzen und der niedrigsten der Phasenimpedanzen entspricht.

**2.** Verfahren nach Anspruch 1, wobei der Schwellenwert periodisch bestimmt wird und es sich bei dem Schwellenwert, der für den Vergleich mit dem Spannungsverhältnis herangezogen wird, um den zuletzt vor der Detektion des fehlenden Neutralleiters bestimmten Schwellenwert handelt.

**3.** Zähler für ein Mehrphasennetz, umfassend:

- Spannungsmessmittel zur Messung der Spannung zwischen den Phasen und einem Bezugspotential des Zählers,
- eine Steuereinheit, die mit den Spannungsmessmitteln verbunden und dafür programmiert ist, das Verfahren gemäß einem der vorhergehenden Ansprüche auszuführen.

**4.** Computerprogrammprodukt zum Ausführen des Verfahrens nach einem der Ansprüche 1 und 2.

**5.** Datenspeichermittel, enthaltend ein Computerprogramm zum Ausführen des Verfahrens nach einem der Ansprüche 1 und 2.

**Claims**

**1.** Method for detecting an absence of neutral in a polyphase network from a counter connecting a consumer installation to the distribution network, the method comprising:

- determine the impedances of the phases downstream of the counter,
- when the impedances are equal to each other, issue an alert indicating that the absence of neutral is impossible to detect,
- when the impedances are unequal to each other, determine the effective voltages between the phases downstream of the counter and a reference potential of the counter,
- calculate a ratio between the highest of these voltages and the lowest of these voltages,
- when this ratio is greater than 1, issue an alert representative of an absence of neutral and actuate a device for disconnecting the counter in the event of detection of an absence of neutral if the voltage ratio is greater than a threshold value greater than 1 and equal to a ratio between the highest of the impedances of the phases and the lowest of the impedances of the phases.

**2.** Method according to claim 1, wherein the threshold value is determined periodically and the threshold value used for the comparison with the voltage ratio is the last threshold value determined before the detection of an absence of neutral.

**3.** Counter for a polyphase network, comprising:

- means for measuring the voltage between the phases and a reference potential of the counter,
- a control unit connected to the voltage measuring means and programmed to implement the method according to any one of the preceding claims.

**4.** Computer program product for carrying out the method according to any one of claims 1 and 2.

**5.** Computer storage means containing a computer program arranged for carrying out the method according to any one of claims 1 and 2.

Fig. 1

Fig. 2